# EUROPEAN PATENT APPLICATION

(11) **EP 4 239 110 A1**
(43) Date of publication of application: **06.09.2023**
(21) Application number: 23155699.4
(22) Date of filing: 08.02.2023
(51) Int. Cl.: C30B 25/14, C23C 16/40, C30B 29/16, H01L 21/00

(54) **CRYSTALLINE OXIDE FILM, MULTILAYER STRUCTURE, AND SEMICONDUCTOR DEVICE**

(30) Priority: 09.02.2022 JP 2022018494; 30.01.2023 JP 2023011846
(71) Applicant: Flosfia Inc., Kyoto 615-8245 (JP)
(72) Inventor: Shinohe, Takashi, Kyoto-shi, 615-8245 (JP); Ando, Hiroyuki, Kyoto-shi, 615-8245 (JP); Higuchi, Yasushi, Kyoto-shi, 615-8245 (JP); Matsuda, Shinpei, Kyoto-shi, 615-8245 (JP); Taniguchi, Kazuya, Aichi-ken, 470-0111 (JP); Watanabe, Hiroki, Aichi-ken, 470-0111 (JP); Matsuki, Hideo, Aichi-ken, 470-0111 (JP)
(74) Representative: Gulde & Partner

(57) **Abstract**

Provided is a crystalline oxide film with excellent semiconductor characteristics. A crystalline oxide film having a plane tilted from a c-plane as a principal plane, and containing gallium and a metal in Group 9 of the periodic table, the metal in Group 9 of the periodic table among all metallic elements in the film having an atomic ratio of equal to or less than 23%.

## Description

### [Technical Field]

The disclosure relates to a crystalline oxide film, a multilayer structure, and a semiconductor device that are useful particularly for power semiconductors.

### [Background Art]

Attention has been focused on a semiconductor device using gallium oxide (Ga₂O₃) having a wide band gap functioning as a next-generation switching element capable of achieving a high breakdown voltage, low loss, and high resistance to heat. Application of such a semiconductor device to a power semiconductor device such as an inverter is expected. Furthermore, the wide band gap is also expected to provide applied use as a light emitting and receiving device such as an LED or a sensor. According to Non-Patent Literature 1, such gallium oxide becomes controllable in band gap by forming mixed crystal using indium or aluminum alone or in combination, and forms an extremely desirable family of materials as InAlGaO-based semiconductors. Here, the InAlGaO-based semiconductors indicate In_{X}Al_{Y}Ga_{Z}O₃ (0 ≤ X ≤ 2, 0 ≤ Y ≤ 2, 0 ≤ Z ≤ 2, X + Y + Z = 1.5 to 2.5) and may be regarded as the same family of materials including gallium oxide (Patent Literature 1).

In recent years, p-type semiconductor based on gallium oxide has been examined. For example, it is described in PTL 2 that, by forming crystal based on β -Ga₂O₃ by the FZ method using MgO (p-type dopant source), a substrate exhibiting p-type conductivity is obtained. It is also described in PTL 3 that p-type semiconductor is formed by adding a p-type dopant to an α-(AlₓGa₁₋ₓ)₂O₃ single crystalline film prepared by the MBE method. However, the methods described in PTLs 2 and 3 find difficulty in realizing p-type semiconductors having semiconductor characteristics applicable to a semiconductor device. For this reason, p-type semiconductor applicable to a semiconductor device using an n-type semiconductor layer containing gallium oxide of a wide band gap has been desired.

### [Related Art]

### [Patent Literature]

PTL 1: WO 2014/050793
PTL 2: JP 2005-340308 A
PTL 3: JP 2013-58637 A

### [Summary of Disclosure]

### [Technical Problem]

One object of the disclosure is to provide a crystalline oxide film with excellent semiconductor characteristics.

### [Solution to Problem]

As a result of earnest examination made to achieve the above-described object, the present inventors have acquired knowledge that, if a crystalline oxide film containing gallium and a metal in Group 9 of the periodic table is deposited using a particular buffer layer (for example, an m-plane α-Ga₂O₃ layer) and if the metal in Group 9 of the periodic table among all metallic elements in the film has an atomic ratio within a particular range (equal to or less than 23%), the crystalline oxide film (a mixed crystal film of an oxide of gallium and an oxide of the metal in Group 9 of the periodic table) having favorable semiconductor characteristics is obtained, and have found that this crystalline oxide film is usable for solving the above-described conventional problem.

The inventors then conducted a further study after obtaining the above findings and completed the present disclosure. That is, the present disclosure relates to the following disclosure.
[1] A crystalline oxide film having a plane tilted from a c-plane as a principal plane, and containing gallium and a metal in Group 9 of the periodic table, the metal in Group 9 of the periodic table among all metallic elements in the film having an atomic ratio of equal to or less than 23%.
[2] The crystalline oxide film according to [1], wherein the crystalline oxide film has a corundum structure.
[3] The crystalline oxide film according to [1] or [2], wherein the principal plane is a plane perpendicular to the c-plane.
[4] The crystalline oxide film according to any one of [1] to [3], wherein the principal plane is an m-plane.
[5] The crystalline oxide film according to any one of [1] to [4], wherein the metal in Group 9 of the periodic table includes iridium.
[6] The crystalline oxide film according to any one of [1] to [5], wherein the crystalline oxide film has a resistivity that decreases in response to temperature increase.
[7] The crystalline oxide film according to any one of [1] to [6], wherein the atomic ratio of the metal in Group 9 of the periodic table in the crystalline oxide film is equal to or less than 10%.
[8] The crystalline oxide film according to any one of [1] to [7], wherein the crystalline oxide film has a thickness of equal to or greater than 100 nm.
[9] The crystalline oxide film according to any one of [1] to [8], wherein the crystalline oxide film has surface roughness (Ra) of equal to or less than 10 nm.
[10] The crystalline oxide film according to any one of [1] to [9], wherein the crystalline oxide film has a p-type conductivity type.
[11] The crystalline oxide film according to any one of [1] to [10], wherein the crystalline oxide film has a band gap of equal to or greater than 5.0 eV
[12] A multilayer structure comprising at least: a first crystalline oxide film containing an oxide of one or two or more types of metals selected from aluminum, indium, and gallium as a major component; and a second crystalline oxide film arranged on the first crystalline oxide film, the first crystalline oxide film having a plane tilted from a c-plane as a principal plane, the second crystalline oxide film containing gallium and a metal in Group 9 of the periodic table, the metal in Group 9 of the periodic table among all metallic elements in the second crystalline oxide film having an atomic ratio of equal to or less than 23%.
[13] The multilayer structure according to [12], wherein the first crystalline oxide film has a corundum structure.
[14] A semiconductor device comprising at least: the crystalline oxide film according to any one of [1] to [11] or the multilayer structure according to [12] or [13]; and an electrode.
[15] A semiconductor system comprising a semiconductor device, the semiconductor device being the semiconductor device according to [14].

### [Advantageous Effect of the Disclosure]

The crystalline oxide film of the disclosure has excellent semiconductor characteristics.

### [Brief Description of Drawings]

FIG. 1 is a schematic configuration view of a deposition device (mist CVD device) used in Example.
FIG. 2 illustrates measurement result about temperature dependency of a resistivity according to Example.
FIG. 3 illustrates measurement result about temperature dependency of a resistivity according to Example.
FIG. 4 illustrates measurement result about temperature dependency of a resistivity according to Comparative Example.
FIG. 5 is a sectional view schematically illustrating a preferred semiconductor device according to an embodiment of the disclosure.
FIG. 6 is a sectional view schematically illustrating a preferred semiconductor device according to an embodiment of the disclosure.
FIG. 7 is a sectional view schematically illustrating a preferred semiconductor device according to an embodiment of the disclosure.
FIG. 8 is a view schematically illustrating a preferred example of a power card.
FIG. 9 is a view schematically illustrating a preferred example of a power source system.
FIG. 10 is a view schematically illustrating a preferred example of a system device.
FIG. 11 is a view schematically illustrating a preferred example of a power source circuit diagram of a power source device.
FIG. 12 is a view illustrating XRD measurement result according to Example.
FIG. 13 is a view illustrating a relationship in value (%) between the depth of a film and an Ir ratio in the film (Ir/(Ga + Ir)) measured by Rutherford backscattering spectrometry (RBS) in Example.

### [Description of Embodiments]

Preferred embodiments of the disclosure will be described below.

A crystalline oxide film of the disclosure is a crystalline oxide film having a plane tilted from a c-plane as a principal plane, and containing gallium a metal in Group 9 of the periodic table, characterized in that the metal in Group 9 of the periodic table among all metallic elements in the film has an atomic ratio of equal to or less than 23%.

According to an embodiment of the disclosure, the c-plane corresponds to a {0001} plane. The plane tilted from the c-plane corresponds to a {11-20} plane (a-plane), a {10-10} plane (m-plane), a {-1012} plane (r-plane), a {10-14} plane (R-plane), a {11-23} plane (n-plane), a { 10-11} plane (S-plane), etc. According to an embodiment of the disclosure, the principal plane of the crystalline oxide film is preferably a plane perpendicular to the c-plane, more preferably, is an m-plane or an a-plane, most preferably, an m-plane. By defining the preferred principal plane in this way, even in the case of a wider band gap (a band gap of equal to or greater than 5.0 eV, for example), it is still possible to obtain a crystalline oxide film of mixed crystal having a p-type conductivity type. The principal plane of the crystalline oxide film includes planes having an off-angle from the foregoing planes. Specifically, if the principal plane is the a-plane, for example, the principal plane includes a plane having an off-angle from the a-plane. A range of the off-angle is not particularly limited unless it interferes with the present disclosure. A range of the off-angle is a range from 0.2° to 12.0°, for example.

The crystalline oxide film contains gallium and a metal in Group 9 of the periodic table, and the metal in Group 9 of the periodic table (this metal may also be called a "metal in Group 9" simply) among all metallic elements in the film has an atomic ratio of equal to or less than 23%. Examples of the metal in Group 9 of the periodic table include cobalt (Co), rhodium (Rh), and iridium (Ir). According to an embodiment of the disclosure, the metal in Group 9 is preferably iridium. The "periodic table" means the periodic table defined by the International Union of Pure and Applied Chemistry (IUPAC).

As long as the content ratio (atomic ratio) of the metal in Group 9 among all the metallic elements in the crystalline oxide film is equal to or less than 23%, this ratio is not particularly limited. According to an embodiment of the disclosure, the content ratio of the metal in Group 9 is preferably equal to or less than 10%. A lower limit of the content ratio (atomic ratio) of the metal in Group 9 in the crystalline oxide film is not particularly limited unless it interferes with the present disclosure. According to an embodiment of the disclosure, the content ratio (atomic ratio) of the metal in Group 9 in the crystalline oxide film is generally equal to or greater than 1%, preferably, equal to or greater than 3%. Gallium in the crystalline oxide film has a content ratio (atomic ratio) that is preferably equal to or greater than 77%, more preferably, equal to or greater than 90%. An upper limit of the content ratio (atomic ratio) of gallium in the crystalline oxide film is not particularly limited unless it interferes with the present disclosure. According to an embodiment of the disclosure, the atomic ratio of gallium in the crystalline oxide film is equal to or greater than 95%, for example. By combining the preferred principal plane and such a preferred range of a content ratio between gallium and the metal in Group 9 of the periodic table (iridium, for example), it becomes possible to obtain a mixed crystal film of an oxide of gallium and an oxide of the metal in Group 9 having a wider band gap (equal to or greater than 5.0 eV, for example) and a p-type conductivity type. The crystalline oxide film has a band gap that is equal to or greater than 4.7 eV, for example, preferably, equal to or greater than 5.0 eV, more preferably, equal to or greater than 5.1 eV

The crystal structure of the crystalline oxide film is also not particularly limited unless it interferes with the present disclosure. Examples of the crystal structure of the crystalline oxide film include a corundum structure, a β-Gallia structure, a hexagonal crystal structure (ε-type structure, for example), an orthorhombic crystal structure (κ-type structure, for example), a cubic structure, and a tetragonal structure. According to an embodiment of the disclosure, the crystalline oxide film preferably has a corundum structure. While the thickness of the crystalline oxide film is not particularly limited, this thickness is preferably equal to or greater than 100 nm according to an embodiment of the disclosure. The surface roughness of the crystalline oxide film is also not particularly limited. According to an embodiment of the disclosure, this surface roughness (Ra) is preferably equal to or less than 10 nm, more preferably, equal to or less than 5 nm. The surface roughness (Ra) mentioned herein means a value obtained by calculation on the basis of JIS B0601 and using result of surface profile measurement about a region of 10 µm square under an atomic force microscope (AFM). By defining these preferred thickness and surface roughness, even a mixed crystal film is still favorably applicable to a semiconductor device, etc.

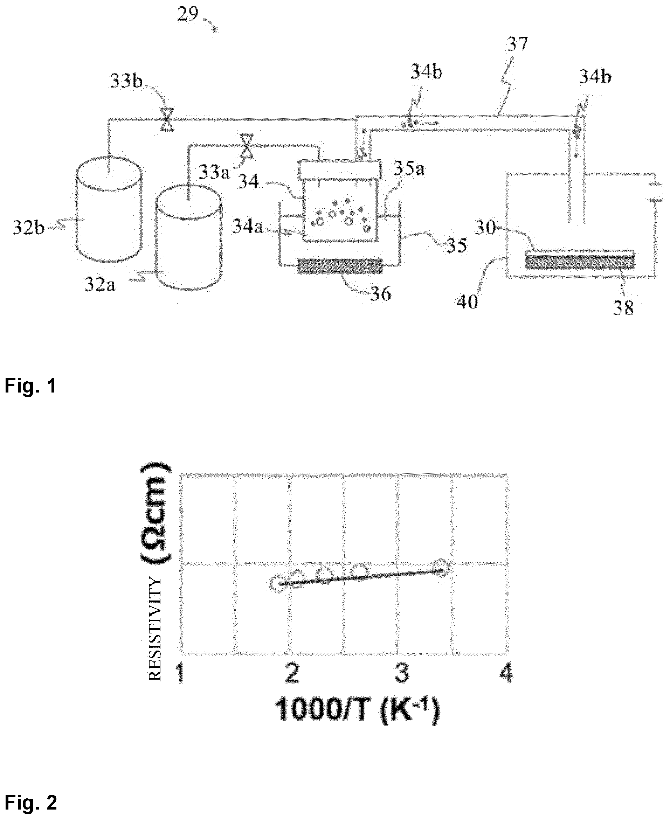

Preferably, the crystalline oxide film of the disclosure is obtained by the following method. According to an embodiment of the disclosure, the method of manufacturing the crystalline oxide film is characterized in that, by using a mist CVD device of a cold wall system such as that illustrated in FIG. 1, for example, a raw material solution containing a metal in Group 9 of the periodic table (this metal may also be called a "metal in Group 9" simply) and gallium is atomized and resultant droplets are caused to float to generate atomized droplets (including mist) (atomization step), the atomized droplets are carried onto a surface of a base using a carrier gas (carrying step), and then a thermal reaction of the atomized droplets is caused to form mixed crystal of a metal oxide containing iridium and gallium on the surface of the base (deposition step).

### (Atomization Step)

At the atomization step, a raw material solution containing at least two types of metals including a metal in Group 9 and gallium is atomized. If desired, the raw material solution may further contain other types of metals. An atomization method is not particularly limited as long as it is available for atomizing the raw material solution and may be a publicly-known method. According to the disclosure, an atomization method using ultrasonic waves is preferred. Atomized droplets obtained using ultrasonic waves are preferred as they have a zero initial velocity and are to float in the air. These atomized droplets are free from damage due to collision energy so considerably preferred as they are a floating mist in space and carriable as a gas, and not to be sprayed as a spray, for example. The droplet size of the atomized droplets is not particularly limited but may be about several millimeters. Preferably, the droplet size is equal to or less than 50 µm, more preferably, from 100 nm to 10 µm.

### (Raw Material Solution)

The raw material solution is not particularly limited as long as it contains a metal in Group 9 and gallium, and may contain an inorganic material or an organic material. If desired, the raw material solution may further contain other types of metals. If the raw material solution contains the metal in Group 9, gallium, and other types of metals, these other types of metals preferably include a metal in Group 2, a metal in Group 9, and/or a metal in Group 13 other than gallium of the periodic table. The raw material solution may contain a metal in Group 9 and gallium. In another case, a raw material solution containing a metal in Group 9 and a raw material solution containing gallium may be subjected to the atomization step separately, and atomized droplets containing the metal in Group 9 and atomized droplets containing gallium obtained from the respective raw material solutions may be combined together in the carrying step or in the deposition step. According to an embodiment of the disclosure, the raw material solution to be used preferably may be prepared by dissolving or dispersing a metal in Group 9 and/or gallium in the form of complex or salt in an organic solvent or water. Examples of the form of the complex include acetylacetonate complexes, carbonyl complexes, ammine complexes, and hydride complexes. Examples of the form of salt include organic metal salts (e.g., metal acetate, metal oxalate, metal citrate, etc.), metal sulfide salt, metal nitrate salt, metal phosphate salt, metal halide salt (e.g., metal chloride salt, metal bromide salt, metal iodide salt, etc.). According to a mist CVD method employed in an embodiment of the disclosure, a film is deposited preferably even at a low concentration of the raw material.

A solvent of the raw material solution is not particularly limited but may be an inorganic solvent such as water, an organic solvent such as alcohol, or a mixed solution of an inorganic solvent and an organic solvent. According to the disclosure, unlike in other conventional deposition methods, the solvent preferably contains water and is also preferably a mixed solvent of water and acid. Specific examples of the water include pure water, ultrapure water, tap water, well water, mineral water, calcareous water, hot spring water, spring water, fresh water, and ocean water. According to the disclosure, ultrapure water is preferred. Specific examples of the acid include organic acids such as acetic acid, propionic acid, and butanoic acid, boron trifluoride, borontrifluoride etherate, boron trichloride, boron tribromide, trifluoroacetic acid, trifluoromethanesulfonic acid, and p-toluenesulfonic acid. According to an embodiment of the disclosure, acetic acid is preferred.

### (Base)

The base is not particularly limited as long as it is available for supporting the crystalline oxide film. A material for the base is also not particularly limited unless it interferes with the present disclosure. The base may be a publicly-known base, or may contain an organic compound or an inorganic compound. The base may be of any shape and may be valid for all shapes. Examples of the shape of the base include a plate shape such as a flat plate or a circular plate, a fibrous shape, a rod shape, a circular columnar shape, a prismatic shape, a tubular shape, a spiral shape, a spherical shape, and a ring shape. According to the disclosure, the base is preferably a substrate. According to the disclosure, the thickness of the substrate is also not particularly limited. As described later, the base may be prepared by stacking a different layer such as a buffer layer on the substrate. The base to be used may include a semiconductor layer having different electrical conductivity.

As long as the substrate has a plate shape and functions as a support for the crystalline oxide film, it is not particularly limited. The substrate may be an insulator substrate, a semiconductor substrate, or a conductive substrate. Preferably, the substrate is an insulator substrate and is also preferably a substrate with a metal film on its surface. Preferably, the substrate may be a substrate having a corundum structure, for example. A material for the substrate is not particularly limited unless it interferes with the present disclosure and may be a publicly-known material. For example, the substrate having a corundum structure is a base substrate containing a substrate material with a corundum structure as a major component. Specific examples of the substrate include a sapphire substrate (preferably, an m-plane sapphire substrate) and an α-type gallium oxide substrate. The "major component" mentioned herein means that the substrate material having the particular crystal structure has a content in terms of an atomic ratio that is preferably equal to or greater than 50% to all components in the semiconductor material, more preferably, equal to or greater than 70%, still more preferably, equal to or greater than 90%, and means the content may be 100%.

### (Carrying Step)

At the carrying step, the mist is carried to the base using the carrier gas. The type of the carrier gas is not particularly limited unless it interferes with the disclosure. Examples of the carrier gas include oxygen, ozone, an inert gas such as nitrogen or argon, and a reducing gas such as hydrogen gas or forming gas. According to the disclosure, oxygen is used preferably as the carrier gas. Examples of the carrier gas using oxygen include air, oxygen gas, and ozone gas. Particularly preferred gas is oxygen gas and/or ozone gas. Furthermore, the carrier gas may have one type, or two or more types. Moreover, a diluted gas (e.g., 10-fold diluted gas) and the like changed in carrier gas concentration may be further used as a second carrier gas. A location for supplying the carrier gas is not limited to one but the carrier gas may be supplied from two or more locations. According to the disclosure, if an atomization chamber, a supply pipe, and a deposition chamber are used, respective locations for supplying the carrier gas are preferably provided at the atomization chamber and the supply tube. More preferably, a location for supplying the carrier gas is provided at the atomization chamber and a location for supplying the diluted gas is provided at the supply pipe. While the flow rate of the carrier gas is not particularly limited, it is preferably from 0.01 to 20 L/min., more preferably, from 1 to 10 L/min. In the case of the diluted gas, the flow rate of the diluted gas is preferably from 0.001 to 5 L/min., more preferably, from 0.1 to 3 L/min.

### (Deposition Step)

At the deposition step, the mist is reacted in the vicinity of a surface of the base to deposit a film on a part of the base surface or on the entire base surface. As long as the reaction is a thermal reaction of forming a film from the atomized droplets, it is not particularly limited but is simply required to be a reaction of the mist using heat. Conditions, etc. for the reaction are also not particularly limited unless they interfere with the present disclosure. At this step, the thermal reaction is generally made at a temperature equal to or higher than an evaporation temperature of a solvent. Preferably, this temperature does not exceed an excessively high temperature. According to the disclosure, the thermal reaction is preferably made at a temperature of equal to or less than 1200°C, more preferably, from 300°C to 700°C or from 750°C to 1200°C, most preferably, from 350°C to 600°C or from 750°C to 1100°C. The thermal reaction may be made in any of atmospheres including vacuum atmosphere, non-oxygen atmosphere, reducing gas atmosphere, and oxidizing atmosphere, and may be made under any of conditions including atmospheric pressure, increased pressure, and reduced pressure unless they interfere with the present disclosure. According to the disclosure, the thermal reaction is preferably made in oxidizing atmosphere and is also preferably made under atmospheric pressure. More preferably, the thermal reaction is made in oxidizing atmosphere and under atmospheric pressure. The "oxidizing atmosphere" is not particularly limited as long as it is an atmosphere allowing formation of the crystalline oxide film through the thermal reaction. For example, the oxidizing atmosphere is formed by using a carrier gas containing oxygen or using mist composed of a raw material solution including an oxidant. The thickness is settable through adjustment of the time of deposition. According to the disclosure, the thickness is preferably from 1 nm to 1 mm, more preferably, from 1 nm to 100 µm in terms of improving semiconductor characteristics further, most preferably, from 1 nm to 10 µm.

According to an embodiment of the disclosure, the film may be deposited directly on the base. Alternatively, after a different layer differing from the crystalline oxide film such as a semiconductor layer (e.g., n-type semiconductor layer, n⁺-type semiconductor layer, or n⁻-type semiconductor layer), an insulator layer (including a semi-insulator layer), or a buffer layer is stacked on the base, the film may be deposited across the different layer over the base. Examples of the semiconductor layer and the insulator layer include a semiconductor layer and an insulator layer each containing the metal in Group 13. Preferred examples of the buffer layer include a semiconductor layer, an insulator layer, and a conductor layer each having a corundum structure. For example, the semiconductor layer having a corundum structure contains α-Fe₂O₃, α-Ga₂O₃, or α-Al₂O₃. A method of stacking the buffer layer is not particularly limited but may be similar to a method of forming the p-type oxide semiconductor.

According to an embodiment of the disclosure, the n-type semiconductor layer is formed preferably before or after deposition of the crystalline oxide film. More specifically, a method of manufacturing the semiconductor device preferably includes at least a step of stacking the crystalline oxide film (p-type semiconductor layer) and the n-type semiconductor layer on each other. A method of forming the n-type semiconductor layer is not particularly limited but may be a publicly-known method. According to the disclosure, a mist CVD method is preferred. Preferably, the n-type semiconductor layer contains oxide semiconductor as a major component, more preferably, contains oxide semiconductor including a metal in Group 13 of the periodic table (Al, Ga, In, or Tl, for example) as a major component. The n-type semiconductor layer also preferably contains crystalline oxide semiconductor as a major component, more preferably, contains crystalline oxide semiconductor including Ga as a major component, most preferably, contains crystalline oxide semiconductor having a corundum structure and including Ga as a major component. The "major component" means that the oxide semiconductor has a content in terms of an atomic ratio that is preferably equal to or greater than 50% to all components in the n-type semiconductor layer, more preferably, equal to or greater than 70%, still more preferably, equal to or greater than 90%, and means the content may be 100%.

By using the preferred manufacturing method described above, it is possible to preferably obtain a multilayer structure including at least a first crystalline oxide film containing an oxide of one or two or more types of metals selected from aluminum, indium, and gallium as a major component, and a second crystalline oxide film formed on the first crystalline oxide film. The multilayer structure is characterized in that the first crystalline oxide film has a plane tilted from a c-plane as a principal plane, the second crystalline oxide film contains gallium and a metal in Group 9 of the periodic table, and the metal in Group 9 of the periodic table among all metallic elements in the second crystalline oxide film has an atomic ratio of equal to or less than 23%.

The crystalline oxide film having the particular composition obtained from the preferred manufacturing method described above is industrially useful and has excellent semiconductor characteristics. By using this preferred manufacturing method, it is possible to obtain a crystalline oxide film that behaves like semiconductor in terms of the temperature characteristics of a resistivity in the crystalline oxide film. More specifically, a resistivity in the crystalline oxide film was found to decrease with temperature increase. By using this preferred manufacturing method, it is possible to obtain the crystalline oxide film having a p-type conductivity type as the crystalline oxide film, in addition to these semiconductor characteristics. The "p-type" mentioned herein means a carrier type determined through Hall effect measurement, scanning capacitance microscopy (SCM), or scanning nonlinear dielectric microscopy (SNDM), for example. While a lower limit of carrier density in the crystalline oxide film (carrier density in the semiconductor film obtained through Hall effect measurement) is not particularly limited, it is preferably equal to or greater than about 1.0 × 10¹⁵/cm³, more preferably, equal to or greater than about 1.0 × 10¹⁸/cm³. According to an embodiment of the disclosure, even with the presence of a metal in Group 9 of the periodic table, it is still possible to obtain a crystalline oxide film having carrier density of equal to or less than about 5.0 × 10¹⁹/cm³ and having the p-type conductivity type. In particular, it is possible to obtain a crystalline oxide film having preferred carrier density such as that described above by setting an Ir ratio among metallic elements in the film equal to or less than 10%. According to an embodiment of the disclosure, it is possible to obtain a crystalline oxide film having carrier density of equal to or less than 2.0 × 10¹⁹/cm³ by setting an Ir ratio among metallic elements in the film equal to or less than 9.5%. While a lower limit of an Ir ratio among metallic elements in a film is not particularly limited, it is equal to or greater than 5%, preferably, equal to or greater than 6.8%, for example.

With the principal plane and with the preferred range of a content ratio between the metal in Group 9 and gallium described above, it is possible to provide the crystalline oxide film with temperature characteristics comparable to those of semiconductor. This issue will be described below using Examples.

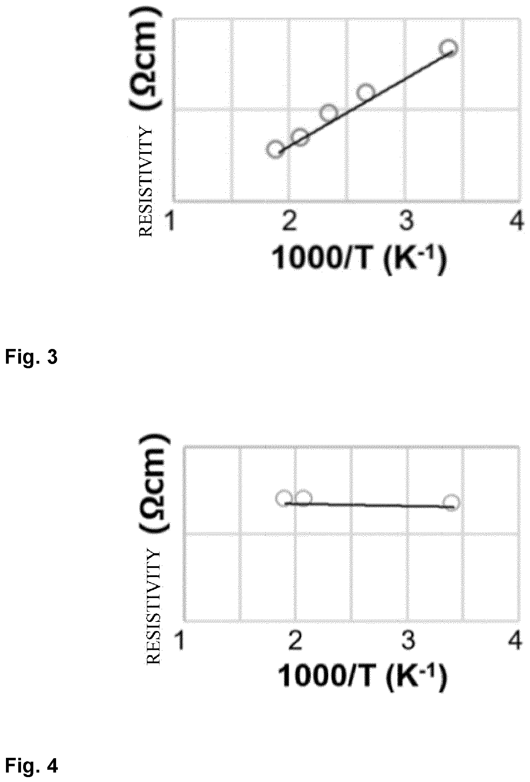

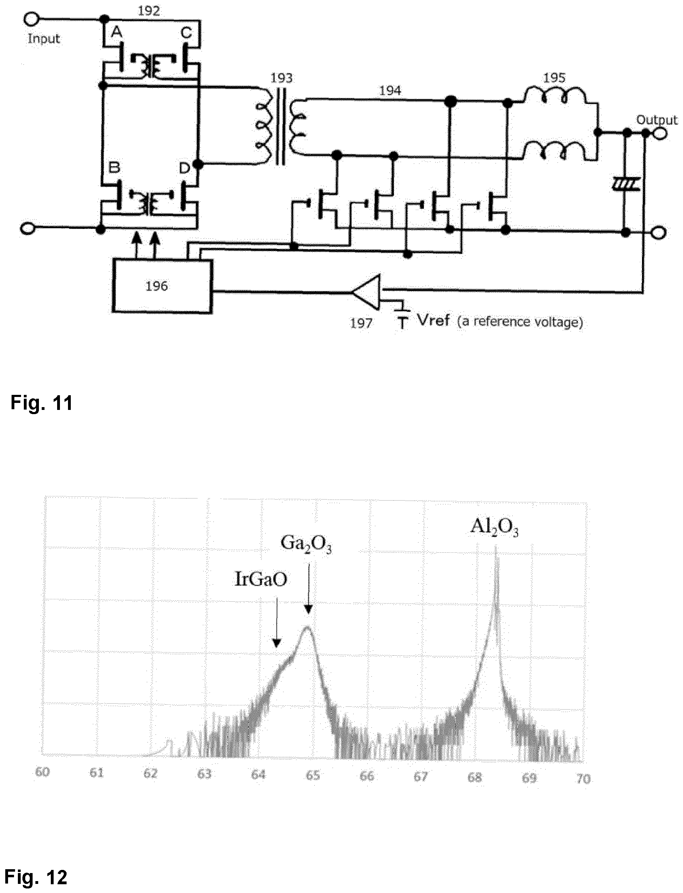

According to Examples, by using the mist CVD device illustrated in FIG. 1, an α-(Ir, Ga)₂O₃ film was deposited on a sapphire substrate having a surface provided with an m-plane α-Ga₂O₃ film. Films were deposited while changing the content ratio of iridium in the films to obtain α-(Ir, Ga)₂O₃ films having characteristics shown in Table 1. The film according to Example 2 was subjected to X-ray diffraction measurement and result thereof is illustrated in FIG. 12. An Ir ratio in the film was calculated using energy dispersive X-ray spectroscopy (EDS). A carrier type was determined through Hall effect measurement. The crystalline oxide film obtained in Example 2 has carrier density of 1.0 × 10¹⁷/cm³ and surface roughness (Ra) of 1.2 nm. Result of observation conducted under a cross-sectional transmission electron microscope (TEM) shows that α-(Ir, Ga)₂O₃ in a favorable shape like a film is obtained. Temperature characteristics were determined by measuring temperature dependency of a resistivity. Results about surface roughness (Ra), etc. obtained in Example 1 are similar to those obtained in Example 2. FIGS. 2, 3, and 4 illustrate results obtained by measuring temperature dependency of a resistivity within a range from ordinary temperature to 250°C according to Example 1, Example 2, and Comparative Example 1 respectively. On the basis of the results in FIGS. 2 to 4, a range of an Ir ratio in which a behavior in terms of temperature characteristics similar to that of semiconductor is exhibited was calculated. As a result, it was known that a behavior in terms of temperature characteristics similar to that of semiconductor is exhibited at an Ir ratio of equal to or less than 23% at which a slope changes from positive to negative. Such a boundary value is new knowledge acquired only after the m-plane α-(Ir, Ga)₂O₃ films were actually formed. Setting such a preferred range makes it possible to provide an m-plane α-(Ir, Ga)₂O₃ film useful as a p-type semiconductor layer in a semiconductor device. To determine reproducibility, the experiment was conducted further and the results thereof show that, in each of the cases where an Ir ratio among metallic elements in a film is 9.5%, 11.7%, and 14.3%, the carrier type, the temperature characteristics of resistivity, and surface roughness (Ra) obtained in these cases are the same as those obtained in Example 1 and Example 2. If the Ir ratio among the metallic elements in the film is 9.5%, carrier density was 1.98 × 10¹⁹/cm³.

**[Table 1]**

| | Ir ratio in film | Carrier type | Temperature characteristics | Thickness (nm) | Band gap (eV) ^{∗}by estimate |
|---|---|---|---|---|---|
| Example 1 | 20.5% (α-(Ir_{0.205,} Ga_{0.795}) | P | Like semiconductor | 123 | 4.7 |
| Example 2 | 6.8% (α-(Ir_{0.068,} Ga_{0.932}) | P | Like semiconductor | 105 | 5.1 |
| Comparative Example 1 | 54.6% (α-(Ir_{0.546}, Ga_{0.454}) | P | Like metal | 117 | 3.9 |

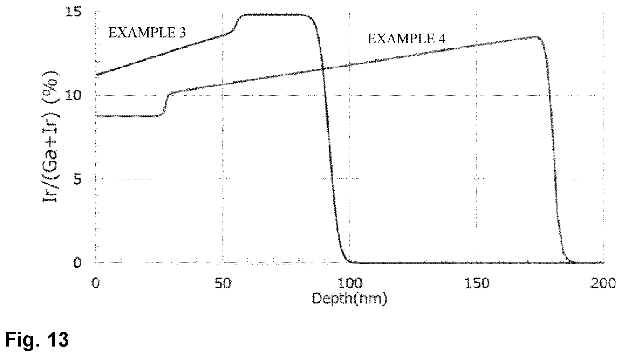

These results from Example 1 and Example 2 show that, by depositing an α-(Ir, Ga)₂O₃ film having an Ir ratio of equal to or less than 10% as a first layer and depositing an α-(Ir, Ga)₂O₃ film having an Ir ratio greater than that of the first layer as a second layer, for example, it is possible to obtain a second crystalline oxide film having more favorable crystallinity and usefulness as a p-type semiconductor layer. According to an embodiment of the disclosure, the first crystalline oxide film and the second crystalline oxide film may be deposited in such a manner that the second layer has an Ir ratio greater than the Ir ratio of the first layer. A relationship in value (%) between the depth of a film deposited in this way and an Ir ratio in the film (Ir/(Ga + Ir)) is illustrated as each of Example 3 and Example 4 in FIG. 13.

The crystalline oxide film obtained in the above-described manner is usable as a p-type semiconductor layer in a semiconductor device, for example, and is particularly useful in a power device. Using the above-described crystalline oxide film and/or multilayer structure in a semiconductor device makes it possible to reduce roughness scattering, thereby achieving excellent channel mobility in the semiconductor device. The semiconductor device is categorizable into a lateral element (lateral device) with an electrode formed on one side of a semiconductor layer and a vertical element (vertical device) with an electrode formed on each of front and back sides of a semiconductor layer. The disclosure is preferably applicable to both the lateral device and the vertical device, and is particularly preferably used in the vertical device. Examples of the semiconductor device include a Schottky barrier diode (SBD), a junction barrier Schottky diode (JBS), a metal semiconductor field-effect transistor (MESFET), a high electron mobility transistor (HEMT), a metal oxide semiconductor field-effect transistor (MOSFET), a static induction transistor (SIT), a junction field-effect transistor (JFET), an insulated gate bipolar transistor (IGBT), and a light-emitting diode.

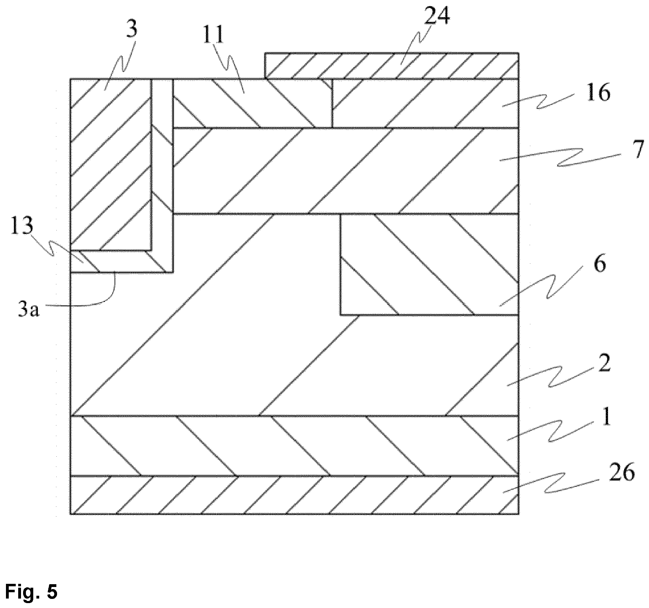

FIGS. 5 to 7 illustrate exemplary uses of the crystalline oxide film as a p-type semiconductor layer. An n-type semiconductor layer may contain an n-type dopant that is the same major component as the crystalline oxide film or may be an n-type semiconductor layer differing from the crystalline oxide film in terms of a major component, etc. According to an embodiment of the disclosure, the n-type semiconductor layer preferably contains a different major component from the crystalline oxide film. The n-type semiconductor layer is used, as appropriate, as an n⁻-type semiconductor layer or an n⁺-type semiconductor layer by being controlled in the content of the n-type dopant, for example.

FIG. 5 illustrates an example of a preferred semiconductor device of the disclosure. The semiconductor device in FIG. 5 is a metal oxide semiconductor field-effect transistor (MOSFET) including an n⁺-type semiconductor layer (drain layer) 1, an n⁻-type semiconductor layer (drift layer) 2, a p⁺-type semiconductor layer (deep p layer) 6, a p⁻-type semiconductor layer (channel layer) 7, an n⁺-type semiconductor layer (n⁺-type source layer) 11, a gate insulating film 13, a gate electrode 3, a p⁺-type semiconductor layer 16, a source electrode 24, and a drain electrode 26. At least a part of the p⁺-type semiconductor layer (deep p layer) 6 is buried in the n⁻-type semiconductor layer 2 to a position deeper than a buried lower end portion 3a of the gate electrode 3. To bring the semiconductor device in FIG. 5 to an on state, a voltage is applied between the source electrode 24 and the drain electrode 26 and a positive voltage relative to the source electrode 24 is applied to the gate electrode 3. Then, a channel is formed at an interface between the p⁻-type semiconductor layer 7 and the gate insulating film 13 to turn on the semiconductor device. To bring the semiconductor device to an off state, the gate electrode 3 is placed at a voltage of 0 V to avoid formation of the channel, thereby turning off the semiconductor device. In the semiconductor device in FIG. 5, the p⁺-type semiconductor layer 6 is buried in the n⁻-type semiconductor layer 2 to a deeper position than the gate electrode 3. This configuration achieves relaxing of an electric field in the vicinity of a lower portion of the gate electrode, making it possible to provide a more favorable electric field distribution in the gate insulating film 13 or in the n⁻-type semiconductor layer 2. According to the disclosure, the crystalline oxide film is preferably used as the p⁺-type semiconductor layer (deep p layer) 6.

As long as materials for the gate electrode, the source electrode, and the drain electrode (these electrodes may also be called "electrodes" simply) are usable for forming the respective electrodes, they are not particularly limited but may be conductive inorganic materials or conductive organic materials. According to the disclosure, the materials for the electrodes are preferably metal, metal compounds, metal oxides, or metal nitrides. The metal is preferably at least one type of metal selected from Group 4 to Group 11 of the periodic table, for example. Examples of metal in Group 4 of the periodic table include titanium (Ti), zirconium (Zr), and hafnium (Hf). Examples of metal in Group 5 of the periodic table include vanadium (V), niobium (Nb), and tantalum (Ta). Examples of metal in Group 6 of the periodic table include one type or two or more types of metals selected from chromium (Cr), molybdenum (Mo), and tungsten (W). Examples of metal in Group 7 of the periodic table include manganese (Mn), technetium (Tc), and rhenium (Re). Examples of metal in Group 8 of the periodic table include iron (Fe), ruthenium (Ru), and osmium (Os). Examples of metal in Group 9 of the periodic table include cobalt (Co), rhodium (Rh), and iridium (Ir). Examples of metal in Group 10 of the periodic table include nickel (Ni), palladium (Pd), and platinum (Pt). Examples of metal in Group 11 of the periodic table include copper (Cu), silver (Ag), and gold (Au).

Means of forming the electrodes is publicly-known means, for example. Specific examples of the forming means include dry method and wet method. Examples of the dry method include publicly-known means such as sputtering, vacuum evaporation, and CVD. Examples of the wet method include screen printing and die coating.

A constituent material for the gate insulating film (interlayer insulating film) is not particularly limited but may be a publicly-known material. Examples of the material for the gate insulating film include an SiO₂ film, an SiON film, an AlON film, an AlN film, an Al2O3 film, an HfO2 film, a phosphorated SiO₂ film (PSG film), a boron-added SiO₂ film, and a phosphorated boron-added SiO₂ film (BPSG film). Examples of a method of forming the gate insulating film include CVD method, atmospheric CVD method, plasma CVD method, ALD method, and mist CVD method. According to an embodiment of the disclosure, the method of forming the gate insulating film is preferably mist CVD method or atmospheric CVD method. Furthermore, a constituent material for the gate electrode is not particularly limited but may be a publicly-known electrode material. Examples of the constituent material for the gate electrode include the constituent materials for the source electrode described above. A method of forming the gate electrode is not particularly limited. Specific examples of the method of forming the gate electrode include dry method and wet method. Examples of the dry method include sputtering, vacuum evaporation, and CVD. Examples of the wet method include screen printing and die coating. The n⁺-type semiconductor layer 1 and the n⁻-type semiconductor layer 2 may be made of materials similar to those for the n-type semiconductor layer described above.

Means of forming each layer of the semiconductor device illustrated in FIG. 5 is not particularly limited unless it interferes with the present disclosure but may be publicly-known means. Examples of the means include means of depositing a film by vacuum evaporation method, CVD method, sputtering method, or various types of coating techniques and then forming a pattern by photolithography method, and means of forming a pattern directly using a technique such as printing. According to the disclosure, mist CVD method is preferred.

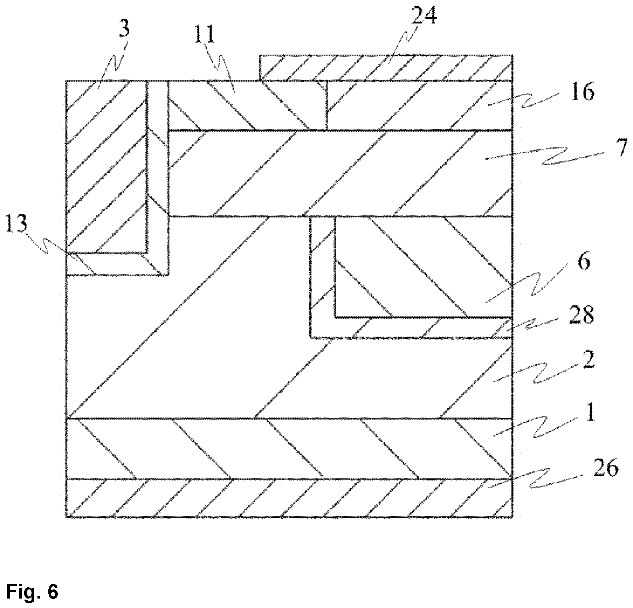

FIG. 6 illustrates another example of a preferred semiconductor device of the disclosure. The semiconductor device in FIG. 6 is a metal oxide semiconductor field-effect transistor (MOSFET), and differs from the semiconductor device in FIG. 5 in that an i-type semiconductor layer 28 is provided between the p⁺-type semiconductor layer (deep p layer) 6 and the n⁻-type semiconductor layer (drift layer) 2. The i-type semiconductor layer 28 is not particularly limited as long as it has carrier density lower than that in the n⁻-type semiconductor layer 2. According to an embodiment of the disclosure, the above-described crystalline oxide film is preferably used as the p⁺-type semiconductor layer 6. According to an embodiment of the disclosure, the i-type semiconductor layer 28 contains a major component that is preferably the same as a major component of the n⁻-type semiconductor layer 2.

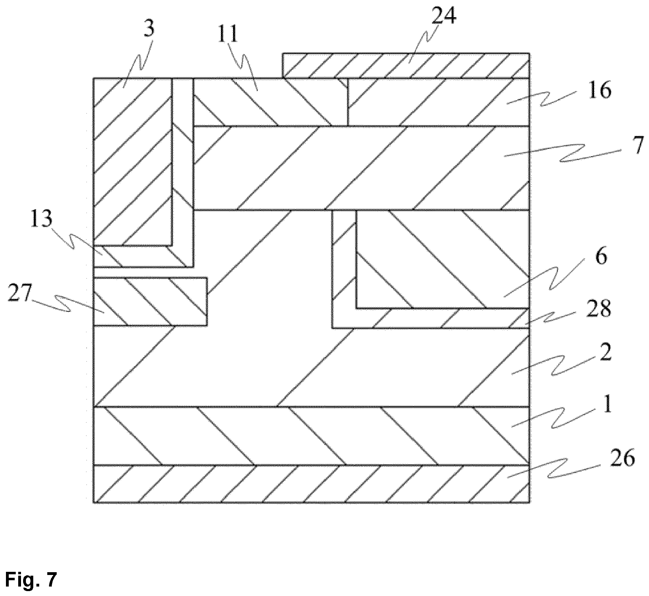

FIG. 7 illustrates another example of a preferred semiconductor device of the disclosure. The semiconductor device in FIG. 7 is a metal oxide semiconductor field-effect transistor (MOSFET), and differs from the semiconductor device in FIG. 6 in that a p-type semiconductor layer 27 is provided near the bottom of a gate. Preferably, the p-type semiconductor layer 27 contains p-type oxide semiconductor as a major component differing from p-type oxide semiconductor as a major component of the p⁻-type semiconductor layer (channel layer) 7. According to the disclosure, the major component of the p-type semiconductor layer 27 may be the same as that of the p⁺-type semiconductor layer 6.

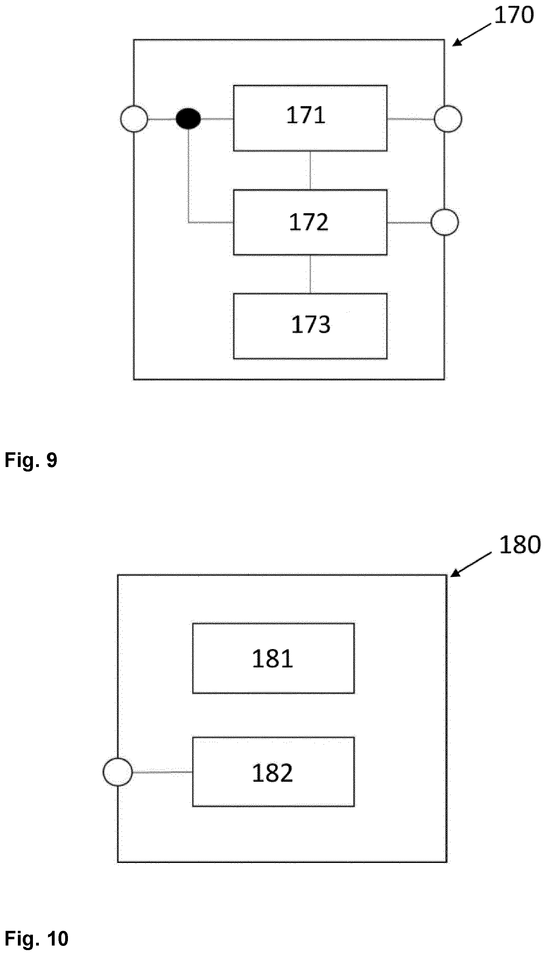

In addition to the above-described matters, by using a publicly-known method further, the semiconductor device according to the disclosure is used preferably as a power module, an inverter, or a converter, and is further used preferably in a semiconductor system using a power source device, for example. The power source device may be provided by connecting the semiconductor device to a wiring pattern, for example, using a publicly-known method. FIG. 9 illustrates an example of a power source system. In FIG. 9, a power source system 170 is configured using a plurality of such power source devices 171 and 172 and a control circuit 173. As illustrated in FIG. 10, the power source system 170 is usable in a system device 180 in combination with an electronic circuit 181. FIG. 11 illustrates an example of a power source circuit diagram of a power source device. FIG. 11 illustrates a power source circuit of a power source device including a power circuit and a control circuit. A DC voltage is switched and converted to AC at a high frequency by an inverter 192 (composed of MOSFETs A to D), and is then subjected to insulation and transformation by a transformer 193. The voltage is then rectified by a rectification MOSFET 194 and thereafter smoothed by a DCL 195 (smoothing coils L1 and L2) and a capacitor to output a direct current voltage. At this point, the output voltage is compared with a reference voltage by a voltage comparator 197 and the inverter 192 and the rectification MOSFET 194 are controlled using a PWM control circuit 196 so as to obtain a desired output voltage.

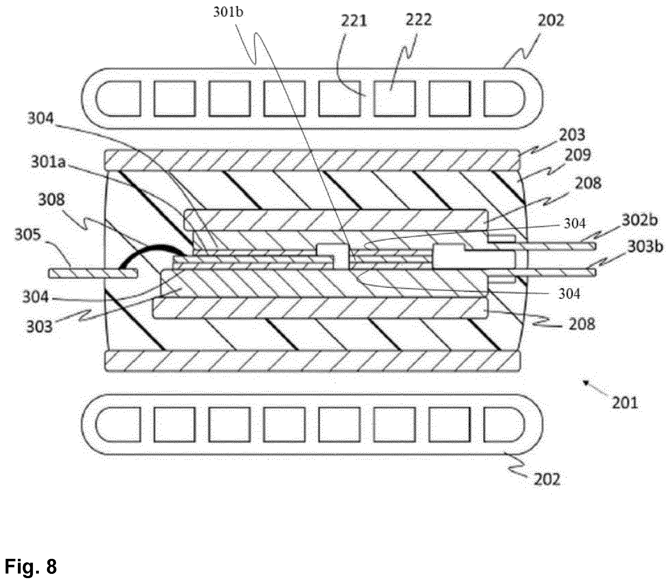

According to the disclosure, the semiconductor device is preferably a power card. More preferably, the power card includes a cooler and an insulating member and the cooler is provided on each of both sides of the semiconductor layer across at least the insulating member. Most preferably, a heat dissipation layer is provided on each of the both sides of the semiconductor layer and the cooler is provided external to the heat dissipation layer across at least the insulating member. FIG. 8 illustrates a power card as one preferred embodiment of the disclosure. The power card in FIG. 8 is a double-sided cooling power card 201 including a coolant tube 202, a spacer 203, an insulating plate (insulating spacer) 208, a resin sealing part 209, a semiconductor chip 301a, a metal heat transfer plate (projecting terminal part) 302b, a heat sink and electrode 303, a metal heat transfer plate (projecting terminal part) 303b, a solder layer 304, a control electrode terminal 305, and a bonding wire 308. The coolant tube 202 has a section in a thickness direction provided with a large number of flow paths 222 separated with a large number of partitions 221 arranged at certain intervals therebetween and extending in a flow path direction. This preferred power card achieves higher heat dissipation performance and fulfills higher reliability.

The semiconductor chip 301a is joined to an inner principal plane of the metal heat transfer plate (projecting terminal part) 302b with the solder layer 304. The metal heat transfer plate (projecting terminal part) 303b is joined to the residual principal plane of the semiconductor chip 301a with the solder layer 304. By doing so, an anode electrode surface and a cathode electrode surface of a flywheel diode 301b are connected in so-called inverse-parallel to a collector electrode surface and an emitter electrode surface of an IGBT. The metal heat transfer plates (projecting terminal parts) 302b and 303b are made of a material that is Mo or W, for example. The metal heat transfer plates (projecting terminal parts) 302b and 303b have a difference in thickness with which a difference in thickness between the semiconductor chips 301a and the flywheel diode 301b is absorbed to define outer surfaces of the metal heat transfer plates 302b and 303b as flat surfaces.

The resin sealing part 209 is made of epoxy resin, for example, and is molded while covering side surfaces of the metal heat transfer plates 302b and 303b. The semiconductor chip 301a and the flywheel diode 301b are molded with the resin sealing part 209. However, the outer principal planes, namely, heat-receiving contact surfaces of the metal heat transfer plates 302b and 303b are completely exposed. The metal heat transfer plates (projecting terminal parts) 302b and 303b project rightward from the resin sealing part 209 in FIG. 8. The control electrode terminal 305 that is a so-called lead frame terminal forms connection between a gate (control) electrode surface and the control electrode terminal 305 of the semiconductor chip 301a where an IGBT is formed, for example.

While the insulating plate 208 as an insulating spacer is composed of an aluminum nitride film, for example, it may be a different insulating film. The insulating plate 208 tightly contacts the metal heat transfer plates 302b and 303b while covering the metal heat transfer plates 302b and 303b completely. Alternatively, the insulating plate 208 may simply contact the metal heat transfer plates 302b and 303b, or a member to transfer heat favorably such as silicone grease may be applied. Various methods are applicable to form a joint therebetween. An insulating layer may be formed by ceramic spraying, for example. The insulating plate 208 may be joined onto the metal heat transfer plate or may be joined onto or formed on the coolant tube.

The coolant tube 202 is prepared by cutting a plate material into a required length that is formed by performing pultrusion molding or extrusion molding on an aluminum alloy. The section in a thickness direction of the coolant tube 202 includes the large number of flow paths 222 separated with the large number of partitions 221 arranged at certain intervals therebetween and extending in the flow path direction. The spacer 203 may be a soft metal plate such as a solder alloy, for example. The spacer 203 may also be a film (coating) formed on the contact surfaces of the metal heat transfer plates 302b and 303b by coating, for example. The soft spacer 203 has a surface that is easy to deform and is adaptable to fine irregularities or distortion of the resin sealing part 209 and to fine irregularities or distortion of the coolant tube 202, thereby reducing thermal resistance. A publicly-known thermally conductive grease and the like may be applied, for example to a surface of the spacer 203. The spacer 203 is omissible.

### [Industrial Applicability]

The crystalline oxide film according to an embodiment of the disclosure is available in any field including semiconductors (e.g., compound semiconductor electronic devices), electronic parts, electric equipment parts, optical electrophotographic related apparatuses, and industrial members, and especially useful for semiconductor devices, etc. for the excellent p-type semiconductor characteristics of the crystalline oxide film.

### [Reference Signs List]

- 1: N⁺-type semiconductor layer
- 2: N'-type semiconductor layer (drift layer)
- 3: Gate electrode
- 3a: Buried lower end portion
- 6: P⁺-type semiconductor layer (deep p layer)
- 7: P⁻-type semiconductor layer (channel layer)
- 11: N⁺-type semiconductor layer
- 13: Gate insulating film
- 16: P⁺-type semiconductor layer
- 24: Source electrode
- 25: Interlayer insulating film
- 26: Drain electrode
- 27: P-type semiconductor layer
- 28: I-type semiconductor layer
- 29: Mist CVD device
- 30: Substrate
- 32a: Carrier gas supplier
- 32b: Carrier gas (diluted) supplier
- 33a: Flow rate control valve
- 33b: Flow rate control valve
- 34: Mist generator
- 34a: Raw material solution
- 34b: Mist
- 35: Container
- 35a: Water
- 36: Ultrasonic transducer
- 37: Supply pipe
- 38: Heater
- 40: Deposition chamber
- 170: Power source system
- 171: Power source device
- 172: Power source device
- 173: Control circuit
- 180: System device
- 181: Electronic circuit
- 182: Power source system
- 192: Inverter
- 193: Transformer
- 194: Rectification MOSFET
- 195: DCL
- 196: PWM control circuit
- 197: Voltage comparator
- 201: Double-sided cooling power card
- 202: Coolant tube
- 203: Spacer
- 208: Insulating plate (insulating spacer)
- 209: Resin sealing part
- 221: Partition
- 222: Flow path
- 301a: Semiconductor chip
- 301b: Flywheel diode
- 302b: Metal heat transfer plate (projecting terminal part)
- 303: Heat sink and electrode
- 303b: Metal heat transfer plate (projecting terminal part)
- 304: Solder layer
- 305: Control electrode terminal
- 308: Bonding wire

## Claims

1. A crystalline oxide film having a plane tilted from a c-plane as a principal plane, and containing gallium and a metal in Group 9 of the periodic table,
the metal in Group 9 of the periodic table among all metallic elements in the film having an atomic ratio of equal to or less than 23%.

2. The crystalline oxide film according to claim 1, wherein
the crystalline oxide film has a corundum structure.

3. The crystalline oxide film according to claim 1 or 2, wherein
the principal plane is a plane perpendicular to the c-plane.

4. The crystalline oxide film according to any one of claims 1 to 3, wherein
the principal plane is an m-plane.

5. The crystalline oxide film according to any one of claims 1 to 4, wherein
the metal in Group 9 of the periodic table includes iridium.

6. The crystalline oxide film according to any one of claims 1 to 5, wherein
the crystalline oxide film has a resistivity that decreases in response to temperature increase.

7. The crystalline oxide film according to any one of claims 1 to 6, wherein
the atomic ratio of the metal in Group 9 of the periodic table in the crystalline oxide film is equal to or less than 10%.

8. The crystalline oxide film according to any one of claims 1 to 7, wherein
the crystalline oxide film has a thickness of equal to or greater than 100 nm.

9. The crystalline oxide film according to any one of claims 1 to 8, wherein
the crystalline oxide film has surface roughness (Ra) of equal to or less than 10 nm.

10. The crystalline oxide film according to any one of claims 1 to 9, wherein
the crystalline oxide film has a p-type conductivity type.

11. The crystalline oxide film according to any one of claims 1 to 10, wherein the crystalline oxide film has a band gap of equal to or greater than 5.0 eV

12. A multilayer structure comprising at least:
a first crystalline oxide film containing an oxide of one or two or more types of metals selected from aluminum, indium, and gallium as a major component; and
a second crystalline oxide film arranged on the first crystalline oxide film,
the first crystalline oxide film having a plane tilted from a c-plane as a principal plane,
the second crystalline oxide film containing gallium and a metal in Group 9 of the periodic table,
the metal in Group 9 of the periodic table among all metallic elements in the second crystalline oxide film having an atomic ratio of equal to or less than 23%.

13. The multilayer structure according to claim 12, wherein
the first crystalline oxide film has a corundum structure.

14. A semiconductor device comprising at least:
the crystalline oxide film according to any one of claims 1 to 11 or the multilayer structure according to claim 12 or 13; and
an electrode.

15. A semiconductor system comprising a semiconductor device,
the semiconductor device being the semiconductor device according to claim 14.
